# FASCICULE DE BREVET EUROPEEN

(11) **EP 1 724 826 B1**
(45) Date de publication et mention de la délivrance du brevet: **11.11.2015**
(21) Numéro de dépôt: 06290810.8
(22) Date de dépôt: 18.05.2006
(51) Int. Cl.: H01L 21/762

(54) **Procédé de détachement d'un film mince**
Verfahren zur Ablösung eines dünnen Films
Process for exfoliating a thin film

(30) Priorité: 20.05.2005 FR 0505091
(43) Date de publication de la demande: 22.11.2006
(73) Titulaire: Commissariat à l'Énergie Atomique et aux Énergies Alternatives, 75015 Paris (FR)
(72) Inventeur: Tauzin, Aurélie, 38950 Saint Martin Le Vinoux (FR)
(74) Mandataire: Colombo, Michel

(56) Documents cités:
- US-B1- 6 323 108
- US-B1- 6 607 969
- DI CIOCCIO L., JALAGUIER E: ET AL.: "III-V layer transfer onto silicon and applications" PHYSICA STATUS SOLIDI A, vol. 202, no. 4, mars 2005 (2005-03), pages 509-515, XP002345962
- PATENT ABSTRACTS OF JAPAN vol. 012, no. 150 (E-606), 10 mai 1988 (1988-05-10) & JP 62 265717 A (NIPPON TELEGR & TELEPH CORP <NTT>), 18 novembre 1987 (1987-11-18)

## Description

### Etat de la technique et problème technique

On connaît déjà, par le document US-5 374 564, un procédé de fabrication de films minces de matériaux semi-conducteurs comprenant les étapes suivantes :
1. bombardement d'une face d'un substrat avec des ions, afin d'implanter ces ions en concentration suffisante pour créer une couche de microbulles gaseuses formant des microcavités définissant une couche de fragilisation ;
2. mise en contact intime de cette face du substrat avec un raidisseur ; et
3. fracture au niveau de la couche de microcavités, par l'application d'un traitement thermique.

Dans ce document, les ions implantés à l'étape 1 sont des ions hydrogène, mais il est indiqué qu'on peut aussi utiliser des ions légers de type hélium ou d'autres gaz rares. Quant au substrat il est, dans les exemples considérés, formé de silicium, mais il est indiqué qu'il peut aussi s'agir de semi-conducteurs du groupe IV de la Table de Mendeleiev, tels que le germanium, le carbure de silicium ou les alliages silicium-germanium.

Dans ce document, la fracture est obtenue au moyen d'un traitement thermique, mais il a ensuite été proposé, dans des variantes du procédé, de provoquer la fracture par un tel traitement thermique et/ou une contrainte de détachement (par exemple, l'insertion d'une lame entre les deux substrats et/ou encore des efforts de traction et/ou de flexion et/ou de cisaillement, et/ou encore l'application d'ultrasons ou de micro-ondes de puissance et de fréquence judicieusement choisies).

On peut noter que ce procédé implique la formation d'une couche de fragilisation formée de microcavités résultant d'ions d'espèces gazeuses, et qu'en pratique, ce sont des ions légers qui ont été implantés. Or le fait d'implanter des ions légers a comme avantage que l'implantation peut se faire aisément jusqu'à des profondeurs significatives, mais la contrepartie est que ces ions ne créent que peu de défauts dans le matériau, et qu'il est donc nécessaire d'en introduire une grande quantité (dose typique supérieure à 10¹⁶, voire 10¹⁷) pour induire une fragilisation suffisante.

On connaît aussi du document US 6323108 B1 que l'implantation d'ions hydrogène peut être accompagnée d'une implantation d'ions bore afin d'obtenir une température de détachement de couche plus faible.

On connaît par ailleurs, par l'article « Ion implantation into GaN » de S.O. Kucheyev, J.S. Williams, S.J. Pearton in Materials Science and Engineering, 33 (2001) 51-107
ou par l'article «Ion implantation in GaN at liquid-nitrogen temperature: Structural characteristics and amorphization » de C. Liu, B. Mensching, M. Zeitler, K. Volz and B. Rauschenbach in Physical Review B de The American Physical Society, 1998, Vol 57, N° 4, pp. 2530-2535,
qu'une implantation d'ions Au ou Ar dans du GaN a divers avantages, notamment en ce qu'elle permet d'implanter une impureté bien définie, à une profondeur bien définie, dans un substrat ; on peut ainsi, notamment, réaliser des dopages précis ou isoler électriquement des volumes précis, ou encore provoquer localement la formation d'inclusions appropriées. Toutefois, des études ont été conduites pour caractériser la détérioration induite par une telle implantation, pour déterminer comment l'éliminer, ou au moins la minimiser.

En effet, un effet induit par l'implantation d'ions d'or dans du GaN est la création d'un désordre cristallin associé à la formation de microcavités qui sont des «bulles» de N₂ qui résultent de l'agglomération d'atomes N du substrat. Les ions implantés provoquent sur leur passage des cascades de déplacements d'atomes du substrat. Ces cascades de collisions induisent un déséquilibre stoechiométrique dans le substrat : l'élément le plus lourd (Ga dans le cas du GaN) est en excès à faible profondeur, tandis que les régions plus profondes sont enrichies avec l'élément le plus léger N. Cet effet est d'autant plus important que la masse des ions implantés est élevée.

L'invention tend à mettre à profit cet inconvénient.

### Définition de l'invention

Elle vise plus précisément à utiliser la dégradation induite par l'implantation d'une espèce lourde non gazeuse, dans un substrat formé d'au moins deux éléments dont au moins l'un peut former une phase gazeuse, pour provoquer la fracture du substrat en une couche mince et un substrat résiduel.

Il mérite d'être noté que, bien que la technologie décrite dans le document US - 5 374 564 précité soit connue depuis de nombreuses années, y compris avant les études concernant l'implantation d'ions Au dans des substrats tels que GaN, il n'avait pas été reconnu que la dégradation induite par cette implantation pouvait être mise à profit pour une fonction de fracture.

Cela peut s'expliquer par le fait que les cavités créées par l'implantation d'une espèce non gazeuse ne contiennent pas d'ions implantés, mais des molécules formées à partir d'un élément constitutif du substrat dans lequel l'implantation a été réalisée, ce qui est foncièrement différent de l'enseignement du document US - 5 374 564 (ou des documents qui ont exploré les variantes du procédé) où la phase gazeuse que l'on peut trouver (lorsqu'elle existe) dans les microcavités est formée d'ions implantés.

En outre, rien ne laissait penser à l'homme de métier que la quantité de gaz, contenue dans les microcavités induites par l'implantation d'ions d'une espèce non gazeuse, pouvait être suffisante pour qu'un traitement thermique ou l'application d'une contrainte mécanique puisse provoquer la fracture.

De plus, la dégradation constatée dans le GaN du fait d'une implantation d'ions Au était décrite comme étant répartie et dispersée dans le volume (par exemple depuis la surface libre des substrats jusqu'à quelques centaines de nanomètres de profondeur), de sorte que rien ne pouvait conduire l'homme de métier à supposer que cette dégradation était néanmoins suffisante pour fragiliser localement le substrat et conduire à une fracture suffisamment bien localisée, en cas de traitement thermique ou d'application de contrainte mécanique, pour permettre la formation d'une couche mince utilisable par la suite.

En d'autres termes, l'invention est fondée sur la constatation qu'une telle implantation d'ions d'une espèce lourde non gazeuse, dans un substrat formé d'au moins deux éléments dont l'un peut former une phase gazeuse, peut aussi aboutir à une fracture, analogue à celle constatée dans la technologie décrite pour la première fois dans le document US - 5 374 564. Par espèce lourde, on entend une espèce de masse atomique supérieure à 20, voire même 40, voire 100.

L'invention propose ainsi un procédé de fabrication de films minces de matériaux semi-conducteurs, par implantation d'ions dans tout substrat composé d'au moins deux éléments différents, dont au moins un de ces éléments peut former une phase gazeuse en se liant avec lui-même et/ou avec des impuretés (résiduelles ou introduites, ...). Par exemple, ce procédé peut s'appliquer aux substrats suivants : GaN, GaAs, a-Si :H, diamant, ...

Le procédé comprend les étapes suivantes :
1. bombardement d'une face du substrat avec des ions, afin d'implanter ces ions d'une espèce lourde non gazeuse en concentration suffisante pour créer dans le substrat une couche de microcavités renfermant une phase gazeuse formée par l'élément du substrat ;
2. mise en contact intime de cette face du substrat avec un raidisseur ; et
3. fracture au niveau de la couche de microcavités, par l'application d'un traitement thermique et/ou d'une contrainte de détachement (par exemple, l'insertion d'une lame entre les deux substrats et/ou encore des efforts de traction et/ou de flexion et/ou de cisaillement, et/ou encore l'application d'ultrasons ou de micro-ondes de puissance et de fréquence judicieusement choisies).

Ainsi, selon ce procédé, et contrairement au procédé décrit dans le document US-5 374 564, les ions implantés à l'étape 1 ne sont pas des espèces gazeuses : les ions implantés sont tout type d'ions lourds non gazeux, (Au, W, Si, Ag...). Le déséquilibre stoechiométrique induit par l'implantation est d'autant plus efficace que la masse des ions implantés est élevée : plus la masse des ions implantés est importante, moins la dose nécessaire à la fracture est importante.

Selon une variante du procédé, on peut obtenir après l'étape 1, une zone de microcavités qui s'étend depuis la surface jusqu'à quelques dizaines, voire centaines, de nanomètres de profondeur sous la surface. On peut ainsi obtenir après implantation un film superficiel de matériau « structuré », constitué d'une matrice (matériau initial) et de microcavités (absence de matière, « void » en anglais), c'est-à-dire un matériau poreux. On peut également obtenir un matériau structuré constitué d'une matrice et de précipités d'ions implantés et/ou d'éléments du matériau initial. Ce type de matériau structuré peut présenter des propriétés optiques et/ou électriques et/ou mécaniques avantageuses par rapport au matériau initial (de même que, par exemple, le Si poreux par rapport au Si). Il est pourtant apparu que, même lorsque cette zone de microcavités s'étend depuis la surface jusqu'à une certaine profondeur, il est possible de provoquer une fracture à une profondeur donnée. En effet, il existe toujours une profondeur telle que la densité et/ou la taille des microcavités est maximale ou encore telle que la contrainte entre la zone de microcavités et la matrice est maximale. Cette profondeur définit la zone de fracture ; il est à la portée de l'homme de métier, compte tenu de son expérience dans la technologie dérivant du document US - 5 374 564, de définir les conditions opératoires pour obtenir cette fracture.

On peut utiliser un traitement thermique après implantation pour faire évoluer les microcavités par diffusion/recombinaison et pour augmenter la pression de la phase gazeuse.

Avant de provoquer la fracture, le film superficiel de matériau structuré peut ensuite être collé sur un raidisseur (étape 2). L'étape 3 de fracture est provoquée au niveau de la couche de microcavités. La localisation et la largeur de la couche de microcavités dépendent de la nature des ions implantés, des paramètres de l'implantation (énergie, dose, température, ...), ainsi que du traitement thermique de fracture éventuel, paramètres que l'homme de métier peut maîtriser sans difficultés particulières. Selon les conditions expérimentales, le film structuré peut donc être transféré en tout ou partie sur le raidisseur.

C'est ainsi que le procédé général de l'invention peut présenter les caractéristiques avantageuses suivantes, prises isolément ou en combinaison :
- le substrat est un nitrure (ce qui donne lieu à la formation d'azote au sein du substrat en conséquence de l'implantation) ; un cas d'intérêt pratique particulier est le nitrure de gallium,
- le substrat est un arséniure, dont un cas d'intérêt particulier est l'arséniure de gallium,
- le substrat est un hydrure (ce qui donne lieu à la formation d'hydrogène gazeux en conséquence de l'implantation), dont un cas d'intérêt particulier est le silicium amorphe hydrogéné α-Si H,
- le substrat est essentiellement formé de carbone et contient un taux d'impuretés résiduelles telles que de l'hydrogène (quantité de l'ordre du % atomique) ; il s'agit par exemple d'un diamant,
- l'ion implanté est un ion de métal lourd ; l'implantation d'ions d'or est en soi déjà bien connue, mais on peut aussi, selon l'invention, implanter d'autres ions tels que tungstène, argent, silicium, césium,
- en variante, l'ion implanté est un ion lourd non métallique, tel que l'erbium, le sélénium, le bismuth,
- l'ion implanté est implanté à une dose comprise entre 10¹² cm⁻² et 10¹⁶ cm⁻², avec une énergie comprise, respectivement entre 2 MeV et 40 keV, la dose étant à adapter en fonction notamment de la masse de l'ion implanté et du matériau à implanter,
- on provoque la fracture par simple traitement thermique,
- on provoque la fracture par au moins application d'une contrainte de détachement (éventuellement en complément d'un traitement thermique) ; cette contrainte peut notamment être appliquée par l'insertion d'une lame entre les deux substrats et/ou encore des efforts de traction et/ou de flexion et/ou de cisaillement, ou encore au moyen d'ultrasons ou de micro-ondes de puissance et de fréquence déterminées.

### Exemple 1

Dans un premier exemple, un substrat GaN (⁷⁰Ga¹⁴N) cristallin est implanté avec des ions Au dans les conditions suivantes : énergie = 2MeV, dose = 10¹⁶ cm⁻². On obtient ainsi des microcavités sphériques (bulles de N₂), de caractéristiques contrôlées (dimensions = dizaines de nanomètres, profondeur depuis la surface jusqu'à 400 nm sous la surface avec des bulles de taille maximale autour de 250 nm). On forme ainsi du GaN poreux, matériau qui peut présenter des propriétés optiques et/ou électriques et/ou mécaniques avantageuses par rapport au GaN. Le substrat GaN poreux est ensuite collé par adhésion moléculaire sur un raidisseur (par exemple saphir). On aura par exemple pour cela prévu avant implantation une couche de SiO₂ sur le substrat GaN. Le substrat de saphir est également muni d'une couche de SiO₂. On procède alors à un polissage mécano-chimique et à la mise en contact des substrats.

Une étape de traitement thermique ou recuit adapté (avec une température comprise entre 200 et 1100°C) permet la diffusion des divers atomes et/ou espèces obtenus après implantation, et/ou la mise sous pression des cavités, pour faire croître les cavités. Cette croissance des microcavités induit des contraintes et la coalescence de certaines d'entre elles, ce qui aboutit au clivage du substrat au niveau de la couche de microcavités.

L'épaisseur de la couche obtenue est de 100 à 400 nm.

### Exemple 2

Dans un second exemple, un substrat GaN (⁷⁰Ga¹⁴N) cristallin, de type wurtzite, est implanté avec des ions Au dans les conditions suivantes : énergie = 300KeV, dose = 610¹⁴ cm⁻². On obtient ainsi des microcavités lenticulaires, de caractéristiques contrôlées (dimensions = quelques dizaines nanomètres, profondeur: jusqu'à 50 nm sous la surface avec une densité maximum de cavités 20 nm sous la surface), dont la taille et la densité sont fonction de la dose implantée. Le substrat GaN ainsi structuré et fragilisé peut alors être soumis à une étape de mise en contact intime avec un raidisseur silicium, par collage moléculaire. L'insertion d'une lame, seule ou en combinaison avec une étape de traitement thermique, par exemple préalable, entraîne le clivage du substrat GaN au niveau de la zone de microcavités. Ce procédé peut être utilisé par exemple pour la réalisation de films minces de GaN « structuré » sur silicium, le film mince étant constitué de la partie du substrat restée sur le raidisseur après clivage.

### Exemple 3

On implante du tungstène dans un substrat Ga.As puis on applique un traitement thermique de recuit à une température supérieure à 450°C.

### Exemple 4

On implante du tungstène dans un substrat α-Si-H.

## Revendications

1. Procédé de fabrication de films minces de matériaux semi-conducteurs, par implantation d'ions dans un substrat composé d'au moins deux éléments différents, dont l'un au moins peut former une phase gazeuse en se liant avec lui-même et/ou avec des impuretés, comportant les étapes suivantes :
(1) bombardement d'une face du substrat avec des ions, afin d'implanter ces ions d'une espèce lourde, c'est-à-dire de masse atomique supérieure à 20, non gazeuse en une concentration suffisante pour créer dans le substrat une couche de microcavités renfermant une phase gazeuse formée par l'élément du substrat ;
(2) mise en contact intime de cette face du substrat avec un raidisseur ; et
(3) fracture au niveau de la couche de microcavités, par l'application d'un traitement thermique et/ou d'une contrainte de détachement

2. Procédé selon la revendication 1, **caractérisé en ce que** l'espèce de ces ions et les conditions d'implantation sont choisies de sorte que la couche de microcavités s'étende jusqu'à la surface du substrat.

3. Procédé selon la revendication 1 ou la revendication 2, **caractérisé en ce que** le substrat est un nitrure.

4. Procédé selon la revendication 3, **caractérisé en ce que** le substrat est un nitrure de gallium.

5. Procédé selon la revendication 1 ou la revendication 2, **caractérisé en ce que** le substrat est un arséniure.

6. Procédé selon la revendication 5, **caractérisé en ce que** le substrat est un arséniure de gallium.

7. Procédé selon la revendication 1 ou la revendication 2, **caractérisé en ce que** le substrat est du silicium amorphe hydrogéné.

8. Procédé selon la revendication 1 ou la revendication 2, **caractérisé en ce que** le substrat est un diamant.

9. Procédé selon la revendication 1 à 8, **caractérisé en ce que** l'ion implanté est un ion de métal lourd.

10. Procédé selon l'une quelconque des revendications 1 à 8, **caractérisé en ce que** l'ion implanté est un ion Au, W, Ag, Si ou Cs.

11. Procédé selon l'une quelconque des revendications 1 à 8, **caractérisé en ce que** l'ion implanté est un ion Er, Se, Bi.

12. Procédé selon l'une quelconque des revendications 1 à 11, **caractérisé en ce que** l'ion implanté est implanté à une dose comprise entre 10¹² cm⁻² et 10¹⁶ cm⁻², avec une énergie comprise, respectivement entre 2 MeV et 40 keV.

13. Procédé selon l'une quelconque des revendications 1 à 12, **caractérisé en ce qu'**on provoque la fracture par simple traitement thermique.

14. Procédé selon l'une quelconque des revendications 1 à 13, **caractérisé en ce qu'**on provoque la fracture par au moins application d'une contrainte de détachement.

15. Procédé selon la revendication 14, **caractérisé en ce que** la contrainte de détachement est appliquée par l'insertion d'une lame entre les deux substrats et/ou encore des efforts de traction et/ou de flexion et/ou de cisaillement.

16. Procédé selon la revendication 15, **caractérisé en ce que** la contrainte de détachement est appliquée au moyen d'ultrasons ou de micro-ondes de puissance et de fréquence adaptées.

## Patentansprüche

1. Verfahren zum Herstellen von Dünnschichten aus Halbleitermaterialien durch Implantieren von Ionen in ein Substrat, das aus wenigstens zwei verschiedenen Elementen aufgebaut ist, wovon wenigstens eines eine Gasphase bilden kann, indem es sich mit sich selbst und/oder mit Fremdstoffen verbindet, das die folgenden Schritte umfasst:
(1) Beschießen einer Fläche des Substrats mit Ionen, um diese Ionen einer schweren Sorte, d. h. mit einer Atommasse größer als 20, die nicht gasförmig sind und eine Konzentration haben, die ausreicht, um in dem Substrat eine Schicht aus Mikrohohlräumen zu erzeugen, die eine durch das Element des Substrats gebildete Gasphase einschließt, zu implantieren;
(2) Herstellen eines engen Kontakts zwischen dieser Fläche des Substrats und einer Versteifung; und
(3) Brechen auf Höhe der Schicht von Mikrohohlräumen durch Anwenden einer thermischen Bearbeitung und/oder einer Lösebeanspruchung.

2. Verfahren nach Anspruch 1, **dadurch gekennzeichnet, dass** die Sorte dieser Ionen und die Implantierungsbedingungen in der Weise gewählt werden, dass sich die Schicht von Mikrohohlräumen bis zu der Oberfläche des Substrats erstreckt.

3. Verfahren nach Anspruch 1 oder Anspruch 2, **dadurch gekennzeichnet, dass** das Substrat ein Nitrid ist.

4. Verfahren nach Anspruch 3, **dadurch gekennzeichnet, dass** das Substrat Galliumnitrid ist.

5. Verfahren nach Anspruch 1 oder Anspruch 2, **dadurch gekennzeichnet, dass** das Substrat ein Arsenid ist.

6. Verfahren nach Anspruch 5, **dadurch gekennzeichnet, dass** das Substrat Galliumarsenid ist.

7. Verfahren nach Anspruch 1 oder Anspruch 2, **dadurch gekennzeichnet, dass** das Substrat hydriertes amorphes Silicium ist.

8. Verfahren nach Anspruch 1 oder Anspruch 2, **dadurch gekennzeichnet, dass** das Substrat Diamant ist.

9. Verfahren nach Anspruch 1 bis 8, **dadurch gekennzeichnet, dass** das implantierte Ion ein Schwermetallion ist.

10. Verfahren nach einem der Ansprüche 1 bis 8, **dadurch gekennzeichnet, dass** das implantierte Ion ein Au-, W-, Ag-, Si- oder Cs-Ion ist.

11. Verfahren nach einem der Ansprüche 1 bis 8, **dadurch gekennzeichnet, dass** das implantierte Ion ein Er-, Se-, Bi-Ion ist.

12. Verfahren nach einem der Ansprüche 1 bis 11, **dadurch gekennzeichnet, dass** das implantierte Ion mit einer Dosis, die im Bereich von 10¹² cm⁻² bis 10¹⁶ cm⁻² liegt, und mit einer Energie im Bereich von 2 MeV bis 40 keV implantiert wird.

13. Verfahren nach einem der Ansprüche 1 bis 12, **dadurch gekennzeichnet, dass** das Brechen durch einfaches thermisches Bearbeiten hervorgerufen wird.

14. Verfahren nach einem der Ansprüche 1 bis 13, **dadurch gekennzeichnet, dass** das Brechen wenigstens durch Ausüben einer Lösebeanspruchung hervorgerufen wird.

15. Verfahren nach Anspruch 14, **dadurch gekennzeichnet, dass** die Lösebeanspruchung durch Einsetzen eines Plättchens zwischen die zwei Substrate und/oder weiterhin durch Zug- und/oder Biege- und/oder Scherungskräfte ausgeübt wird.

16. Verfahren nach Anspruch 15, **dadurch gekennzeichnet, dass** die Lösebeanspruchung mittels Ultraschall oder Leistungsmikrowellen mit angepassten Frequenzen ausgeübt wird.

## Claims

1. Method of fabricating thin films of semiconductor materials by implanting ions in a substrate composed of at least two different elements at least one of which can form a gaseous phase on bonding with itself and/or with impurities, the method including the following steps:
(1) bombarding one face of the substrate with ions of a non-gaseous heavy species, that is to say having an atomic weight greater than 20, in order to implant those ions in a concentration sufficient to create in the substrate a layer of microcavities containing a gaseous phase formed by the element of the substrate;
(2) bringing this face of the substrate into intimate contact with a stiffener; and
(3) obtaining cleavage at the level of the microcavity layer by the application of heat treatment and/or a splitting stress.

2. Method according to Claim 1, **characterized in that** the species of the ions and the implantation conditions are selected so that the layer of microcavities extends as far as the surface of the substrate.

3. Method according to Claim 1 or Claim 2, **characterized in that** the substrate is a nitride.

4. Method according to Claim 3, **characterized in that** the substrate is gallium nitride.

5. Method according to Claim 1 or Claim 2, **characterized in that** the substrate is an arsenide.

6. Method according to Claim 5, **characterized in that** the substrate is gallium arsenide.

7. Method according to Claim 1 or Claim 2, **characterized in that** the substrate is hydrogenated amorphous silicon.

8. Method according to Claim 1 or Claim 2, **characterized in that** the substrate is diamond.

9. Method according to any one of Claims 1 to 8, **characterized in that** the implanted ion is a heavy metal ion.

10. Method according to any one of Claims 1 to 8, **characterized in that** the implanted ion is an Au, W, Ag, Si or Cs ion.

11. Method according to any one of Claims 1 to 8, **characterized in that** the implanted ion is an Er, Se or Bi ion.

12. Method according to any one of Claims 1 to 11, **characterized in that** the implanted ion is implanted at a dose from 10¹² cm⁻² to 10¹⁶ cm⁻² with an energy from 2 MeV to 40 keV, respectively.

13. Method according to any one of Claims 1 to 12, **characterized in that** cleavage is brought about simply by heat treatment.

14. Method according to any one of Claims 1 to 13, **characterized in that** the cleavage is brought about at least by application of a splitting stress.

15. Method according to Claim 14, **characterized in that** the splitting stress is applied by inserting a blade between the two substrates and/or by applying further traction and/or bending and/or shear forces.

16. Method according to Claim 15, **characterized in that** the splitting stress is applied by means of ultrasound or microwaves of appropriate power and frequency.
